# EUROPÄISCHE PATENTANMELDUNG

(11) **EP 3 696 300 A1**
(43) Veröffentlichungstag der Anmeldung: **19.08.2020**
(21) Anmeldenummer: 19157819.4
(22) Anmeldetag: 18.02.2019
(51) Int. Cl.: C30B 23/02, C23C 14/00, C30B 23/04, C30B 25/04, C30B 25/08, C30B 29/40, H01L 21/00

(54) **VERFAHREN ZUR HERSTELLUNG EINES VERBUNDMATERIALKÖRPERS INSBESONDERE FÜR DIE VERWENDUNG BEI DER HERSTELLUNG VON ELEKTRONISCHEN ODER OPTOELEKTRONISCHEN BAUELEMENTEN**

(71) Anmelder: Aixatech GmbH, 52499 Baesweiler (DE)
(72) Erfinder: Dikme, Yilmaz, 52499 Baesweiler (DE)
(74) Vertreter: dompatent von Kreisler Selting Werner - Partnerschaft von Patent- und Rechtsanwälten mbB

(57) **Zusammenfassung**

Bei dem Verfahren zur Herstellung eines Verbundmaterialkörpers insbesondere für die Verwendung bei der Herstellung von elektronischen oder optoelektronischen Bauelementen wird z.B. auf einer Materialschicht eine das Aufwachsenlassen eines Elementhalbleiter- oder Verbindungshalbleitermaterials verhindernde Abdeckschicht, insbesondere eine SiOₓ-Schicht - oder SiNₓ-Schicht, aufgebracht, die zur Erzeugung von Öffnungen oder Vertiefungen maskiert ist und/oder maskiert wird, wobei innerhalb der Öffnungen oder Vertiefungen die auf dem Substrat aufgewachsene Materialschicht freiliegt. Alternativ kann aber auch die Materialschicht selbst strukturiert werden, und zwar zur Ausbildung von einzelnen Inseln der Materialschicht mit bis zur Substratschicht tiefen Aussparungen. Ferner ist es möglich, dass eine Substratschicht eine Oberseite aufweist, die mit einer Vielzahl von durch nicht-ebene Zwischenbereiche voneinander getrennten ebenen Substratflächenbereichen versehen ist und dass das Aufwachsenlassen der Materialschicht nur auf den ebenen Substratflächenbereichen erfolgt. Ferner ist es möglich, dass eine Substratschicht eine strukturierte Oberseite mit erhabenen Bereichen und mit Vertiefungen zwischen diesen aufweist, dass die erhabenen Bereiche Oberseiten mit jeweils mindestens einer ebenen Oberfläche und die Vertiefungen nicht-ebene, insbesondere raue, Bodenflächen aufweisen und dass das Aufwachsenlassen von Material der Materialschicht nur auf den ebenen Oberflächen der erhabenen Bereiche erfolgt. Ferner ist es möglich, dass auf einer Substratschicht eine das Aufwachsenlassen eines Elementhalbleiter- oder Verbindungshalbleitermaterials verhindernde Abdeckschicht, insbesondere eine SiOₓ- oder SiNₓ-Schicht, aufgebracht wird, die zur Entstehung von bis zur ebenen Substratfläche tiefen Aussparungen maskiert ist und/oder maskiert wird, wobei zumindest innerhalb der Aussparungen und ggf. darüber hinaus nach oben erstreckend Material der Materialschicht aufwächst.

## Beschreibung

Die Erfindung betrifft ein Verfahren zur Herstellung eines Verbundmaterialkörpers insbesondere für die Verwendung bei der Herstellung von elektronischen oder optoelektronischen Bauelementen. Insbesondere betrifft die Erfindung ein Verfahren für das Wachstum von organischen und/oder anorganischen Schichten auf strukturierten Schichten, hergestellt nach dem Verfahren gemäß DE 10 2013 112 785 B3, und die Strukturierung derartig hergestellter Schichten.

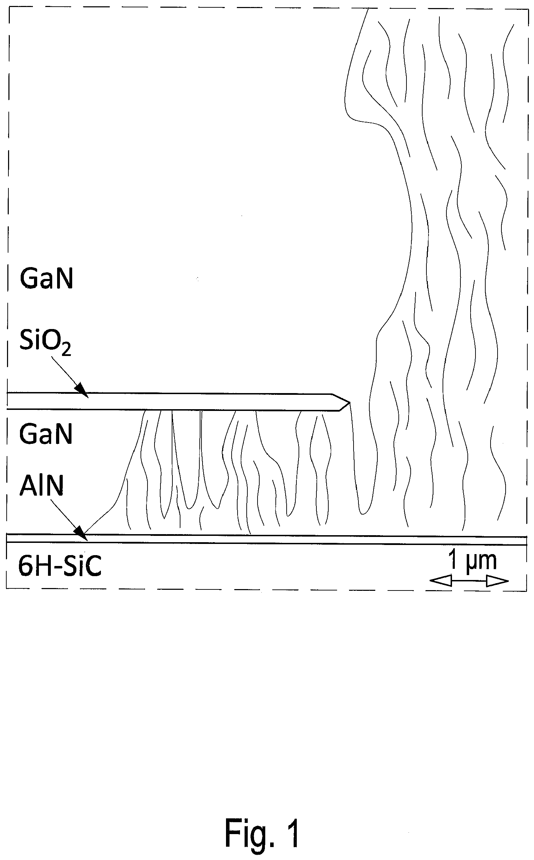

Für das Wachstum von Halbleiterschichten für elektronische und optoelektronische Anwendungen dient als Keimzelle das Substrat. Aus Kostengründen kann nicht immer das Substrat verwendet werden, welches aus dem identischen Material besteht wie das der ersten gewachsenen Materialschicht. Das Wachstum von Halbleitermaterial (, das im Weiteren als Beispiel für ein auf einem Substrat aufwachsendes Material betrachtet wird,) auf einem Fremdsubstrat, welches eine ähnliche Kristallgittersymmetrie wie das aufzuwachsende Halbleitermaterial aufweist, wird Heteroepitaxie genannt (im Gegensatz zur Homoepitaxie). Auf Grund von nur leicht unterschiedlichen Gitterparametern des Substrats und der ersten Materialschicht kommt es in der aufgewachsenen Schicht zu Defekten, sogenannten Versetzungen. Die Versetzungen haben einen negativen Einfluss auf die Performance und Lebensdauer des Bauelements. Daher werden verschiedene Methoden angewendet, um die Versetzungsdichte zu reduzieren. Die Basisidee ist, dass kleine Stellen auf der Oberfläche des Substrats maskiert werden. An dieser Stelle bekommt die Materialschicht von unten keine Wachstumsinformation und diese Stellen werden von den Seiten her zugewachsen. In Fig. 1 erkennt man, dass das Halbleitermaterial oberhalb einer z.B. durch SiO₂ maskierten Stelle kaum Versetzungslinien zeigt, während seitlich der Stelle Versetzungslinien bis nach oben reichen.

Aus DE 10 2013 112 785 B3 ist ein Verfahren bekannt, bei dem keramisches Material, metallischer Hartstoff oder Halbleitermaterial mit geringen Temperaturen gewachsen werden kann. Abhängig von der Schicht, die aufgewachsen wird, und von dem Substrat, kann die Schicht epitaktisch, also einkristallin als Basisschicht auf einem Substrat aus z.B. Saphir (oder Si-111) gewachsen werden. So ist z.B. die Prozesstemperatur für das epitaktische Wachstum mit dem Standard-Verfahren der MOCVD (metal organic chemical vapor deposition, chemische Gasphasenabscheidung) für Aluminiumnitrid (AIN) oder 5 bis 10 mal deutlich höher als beim Verfahren nach DE 10 2013 112 785 B3. Insgesamt sind die Produktionskosten über 80 % geringer als mittels MOCVD. Es konnte bereits gezeigt werden, dass z.B. Halbleitermaterial mittels MOCVD auf einer nach DE 10 2013 112 785 B3 auf einem Substrat hergestellten Schicht (nachfolgend als Basisschicht bezeichnet) weitergewachsen werden kann, wobei es wünschenswert ist, die Kristallqualität der nachfolgenden Schichten weiter zu steigern, sei es mit MOCVD oder auch weiter mit dem nach DE 10 2013 112 785 B3-Verfahren.

Aufgabe der Erfindung ist es, ein Verfahren für das Wachstum von organischen und anorganischen Schichten auf Substraten anzugeben, bei denen Kristallstörungen in Form von Kristallversetzungen beim Wachstum weiter reduziert werden. Weiter besteht die Aufgabe die Kontaktfläche zum Substrat zu reduzieren, um Spannungen abzubauen und/oder einfacher das Substrat von der Materialschicht trennen zu können.

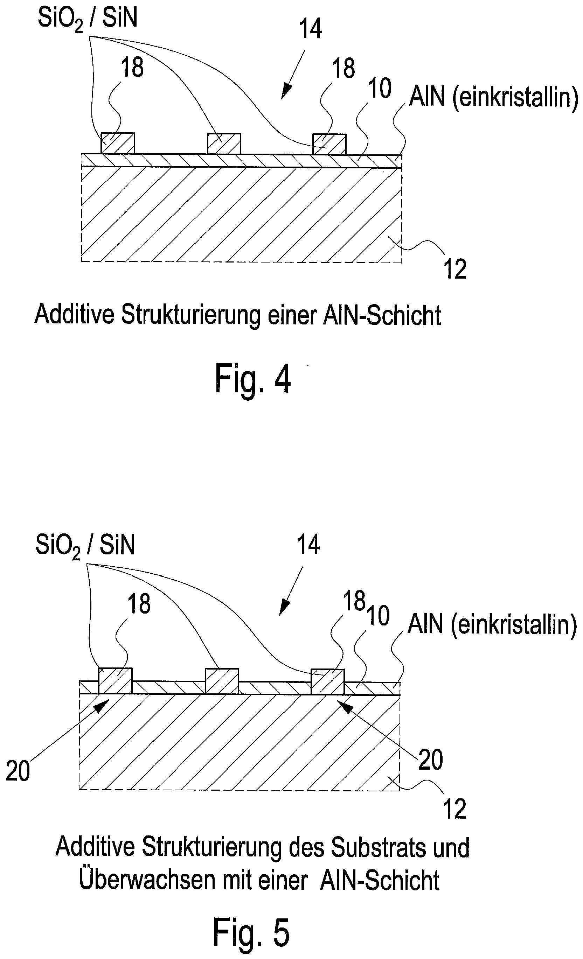

Zur Lösung dieser Aufgabe wird gemäß einer ersten Variante der Erfindung (schematisch in Fig. 4 gezeigt) ein Verfahren zur Herstellung eines Verbundmaterialkörpers insbesondere für die Verwendung bei der Herstellung von elektronischen oder opto-elektronischen Bauelementen vorgeschlagen, wobei bei dem Verfahren
- ein Schichtenaufbau bereitgestellt wird, der eine Substratschicht, insbesondere eine Saphirschicht oder eine Si-111-Schicht, mit mindestens einer ebenen Substratfläche und mit mindestens einer polykristallinen oder einkristallinen oder im Wesentlichen einkristallinen Materialschicht auf der mindestens einen ebenen Substratfläche aufweist,
- wobei der Schichtenaufbau hergestellt wird durch folgende Schritte:
   - Erwärmung mindestens eines Teils der ebenen Substratfläche auf eine Temperatur von mindestens 100 °C und höchstens 550 °C, und zwar für die Dauer der Herstellung des Schichtenaufbaus,
   - Reinigen der Substratfläche durch Zuführen von Wasserstoff oder Sauerstoff oder einem anderen reaktiven Gas aus einer ersten oder einer zweiten Materialquelle und einem Plasma,
   - Terminieren der Substratfläche durch Aufbringen von Kohlenstoff, Stickstoff oder Sauerstoff aus der ersten Materialquelle oder aus einer weiteren Materialquelle und einem Plasma und
   - Aufwachsenlassen der mindestens einen Materialschicht durch Zuführen von Material aus der ersten Materialquelle oder der zweiten und der weiteren oder einer anderen Materialquelle zu der mindestens einen ebenen Substratfläche,
- wobei auf die Materialschicht eine das Aufwachsenlassen von polykristallinem oder einkristallinem oder im Wesentlichen einkristallinem Material verhindernde Abdeckschicht, insbesondere eine SiOₓ- oder SiNₓ-Schicht, aufgebracht wird, die zur Erzeugung von Öffnungen oder Vertiefungen durch z.B. Ätzen, insbesondere nasschemisches Ätzen oder durch einen Trockenätzprozess und/oder Laser- und/oder Elektronenstrahlstrukturierung und/oder durch Fotolithographie oder durch Kombinationen der zuvor beschriebenen Prozesse maskiert ist und/oder maskiert wird, wobei innerhalb der Öffnungen oder Vertiefungen die auf dem Substrat aufgewachsene Materialschicht freiliegt.

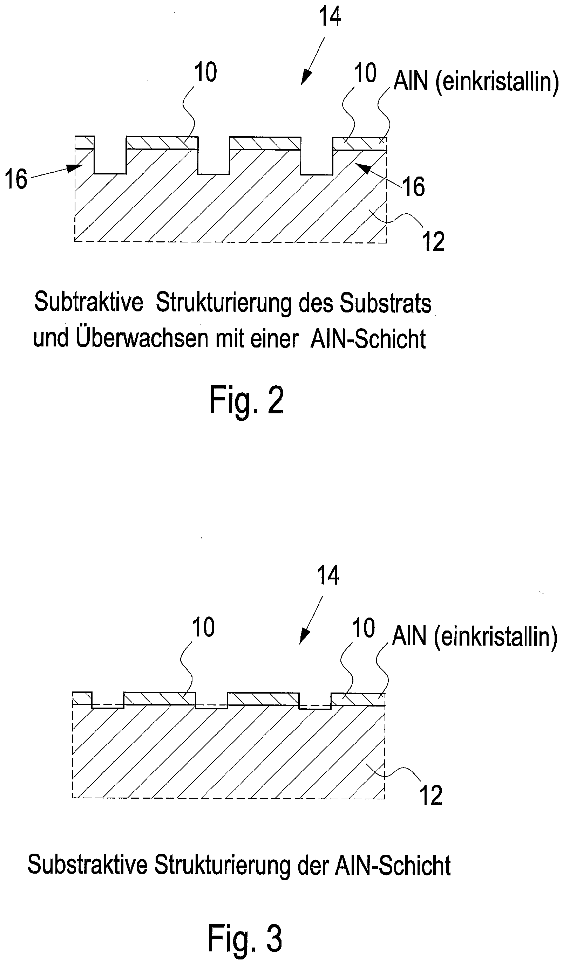

Zur Lösung dieser Aufgabe wird gemäß einer zweiten Variante der Erfindung (schematisch in Fig. 3 gezeigt) ein Verfahren zur Herstellung eines Verbundmaterialkörpers insbesondere für die Verwendung bei der Herstellung von elektronischen oder optoelektronischen Bauelementen vorgeschlagen, wobei bei dem Verfahren
- ein Schichtenaufbau bereitgestellt wird, der eine Substratschicht, insbesondere eine Saphirschicht oder eine Si-111-Schicht, mit mindestens einer ebenen Substratfläche und mit mindestens einer polykristallinen oder einkristallinen oder im Wesentlichen einkristallinen Materialschicht auf der mindestens einen ebenen Substratfläche aufweist,
- wobei der Schichtenaufbau hergestellt wird durch folgende Schritte:
   - Erwärmung mindestens eines Teils der ebenen Substratfläche auf eine Temperatur von mindestens 100 °C und höchstens 550 °C, und zwar für die Dauer der Herstellung des Schichtenaufbaus,
   - Reinigen der Substratfläche durch Zuführen von Wasserstoff oder Sauerstoff oder einem anderen reaktiven Gas aus einer ersten oder einer zweiten Materialquelle und einem Plasma,
   - Terminieren der Substratfläche durch Aufbringen von Kohlenstoff, Stickstoff oder Sauerstoff aus der ersten Materialquelle oder aus einer weiteren Materialquelle und einem Plasma und
   - Aufwachsenlassen der mindestens einen Materialschicht durch Zuführen von Material aus der ersten oder der zweiten Materialquelle und der weiteren oder einer anderen Materialquelle zu der mindestens einen ebenen Substratfläche,
- wobei die aufgewachsene Materialschicht zur Ausbildung von einzelnen Inseln mit bis zur Substratschicht tiefen oder mit sich bis in die Substratschicht hinein erstreckenden Aussparungen strukturiert, insbesondere nasschemisch und/oder durch einen Trockenätzprozess und/oder Laser- und/oder Elektronenstrahlstrukturierung und/oder durch Fotolithographie oder durch Kombinationen der zuvor beschriebenen Prozesse strukturiert wird.

Zur Lösung dieser Aufgabe wird gemäß einer dritten Variante der Erfindung (schematisch in Fig. 2 gezeigt) ein Verfahren zur Herstellung eines Verbundmaterialkörpers insbesondere für die Verwendung bei der Herstellung von elektronischen oder optoelektronischen Bauelementen vorgeschlagen, wobei bei dem Verfahren
- ein Schichtenaufbau bereitgestellt wird, der eine Substratschicht, insbesondere eine Saphirschicht oder eine Si-111-Schicht, mit mindestens einer ebenen Substratfläche und mit mindestens einer polykristallinen oder einkristallinen oder im Wesentlichen einkristallinen Materialschicht auf der mindestens einen ebenen Substratfläche aufweist,
- wobei der Schichtenaufbau hergestellt wird durch folgende Schritte:
   - Erwärmung mindestens eines Teils der ebenen Substratfläche auf eine Temperatur von mindestens 100 °C und höchstens 550 °C, und zwar für die Dauer der Herstellung des Schichtenaufbaus,
   - Reinigen der Substratfläche durch Zuführen von Wasserstoff oder Sauerstoff oder einem anderen reaktiven Gas aus einer ersten oder einer zweiten Materialquelle und einem Plasma,
   - Terminieren der Substratfläche durch Aufbringen von Kohlenstoff, Stickstoff oder Sauerstoff aus der ersten Materialquelle oder aus einer weiteren Materialquelle und einem Plasma und
   - Aufwachsenlassen der mindestens einen Materialschicht durch Zuführen von Material aus der ersten Materialquelle oder der zweiten und der weiteren oder einer anderen Materialquelle zu der mindestens einen ebenen Substratfläche,
- wobei die Substratschicht durch z.B. nasschemisches Ätzen oder mechanische Bearbeitung oder durch einen Trockenätzprozess und/oder Laser- und/oder Elektronenstrahlstrukturierung und/oder durch Fotolithographie oder durch Kombinationen der zuvor beschriebenen Prozesse zur Erzeugung einer strukturierten Oberseite mit erhabenen Bereichen und mit Vertiefungen zwischen diesen verarbeitet wird,
- wobei die erhabenen Bereiche Oberseiten mit jeweils mindestens einer ebenen Oberfläche und die Vertiefungen nicht-ebene, insbesondere raue, Bodenflächen, oder umgekehrt, aufweisen und
- wobei nach den oben genannten Schritten des Erwärmens, des Reinigens und des Terminierens das Aufwachsenlassen von Material der Materialschicht nur auf den ebenen Oberflächen der erhabenen Bereiche oder der ebenen Bodenflächen der Vertiefungen erfolgt.

Wird die Substratoberfläche beispielsweise durch nasschemisches Ätzen strukturiert, so erfolgt dieses Ätzen nicht gleichmäßig, was z.B. für den Fall des Ätzens von Si-100 mittels Kaliumhydroxid gilt, so dass also eine Pyramidenstruktur entsteht und die Materialschicht auf den schrägen Seitenflächen wächst. Zur Lösung dieser Aufgabe wird gemäß einer vierten Variante der Erfindung (schematisch in Fig. 5 gezeigt) ein Verfahren zur Herstellung eines Verbundmaterialkörpers insbesondere für die Verwendung bei der Herstellung von elektronischen oder optoelektronischen Bauelementen vorgeschlagen, wobei bei dem Verfahren
- ein Schichtenaufbau bereitgestellt wird, der eine Substratschicht, insbesondere eine Saphirschicht oder eine Si-111-Schicht, mit mindestens einer ebenen Substratfläche und mit mindestens einer polykristallinen oder einkristallinen oder im Wesentlichen einkristallinen Materialschicht auf der mindestens einen ebenen Substratfläche aufweist,
- wobei der Schichtenaufbau hergestellt wird durch folgende Schritte:
   - Erwärmung mindestens eines Teils der ebenen Substratfläche auf eine Temperatur von mindestens 100 °C und höchstens 550 °C, und zwar für die Dauer der Herstellung des Schichtenaufbaus,
   - Reinigen der Substratfläche durch Zuführen von Wasserstoff oder Sauerstoff oder einem anderen reaktiven Gas aus einer ersten oder einer zweiten Materialquelle und einem Plasma,
   - Terminieren der Substratfläche durch Aufbringen von Kohlenstoff, Stickstoff oder Sauerstoff aus der ersten Materialquelle oder aus einer weiteren Materialquelle und einem Plasma und
   - Aufwachsenlassen der mindestens einen Materialschicht durch Zuführen von Material aus der ersten Materialquelle oder der zweiten und der weiteren oder einer anderen Materialquelle zu der mindestens einen ebenen Substratfläche,
- wobei auf der Substratschicht durch Auftragen, insbesondere durch Aufwachsenlassen einer von polykristallinem oder einkristalliniem oder im Wesentlichen einkristallinem Material verhindernden Abdeckschicht, insbesondere einer SiOₓ- oder SiNₓ-Schicht, verarbeitet wird, die zur Erzeugung von bis zur ebenen Substratfläche tiefen Öffnungen oder Aussparungen z.B. durch Ätzen, insbesondere nasschemisches Ätzen oder durch einen Trockenätzprozess und/oder Laser- und/oder Elektronenstrahlstrukturierung und/oder durch Fotolithographie oder durch Kombinationen der zuvor beschriebenen Prozesse maskiert ist und/oder maskiert wird, und
- wobei nach den oben genannten Schritten des Erwärmens, des Reinigens und des Terminierens zumindest innerhalb der Aussparungen und ggf. darüber hinaus nach oben erstreckend Material der Materialschicht aufwächst.

Zur Lösung dieser Aufgabe wird gemäß einer weiteren Variante der Erfindung (in ähnlicher Form in Fig. 2 gezeigt) ein Verfahren zur Herstellung eines Verbundmaterialkörpers insbesondere für die Verwendung bei der Herstellung von elektronischen oder optoelektronischen Bauelementen vorgeschlagen, wobei bei dem Verfahren
- ein Schichtenaufbau bereitgestellt wird, der eine Substratschicht, insbesondere eine Saphirschicht oder eine Si-111-Schicht, mit mindestens einer ebenen Substratfläche und mit mindestens einer polykristallinen oder einkristallinen oder im Wesentlichen einkristallinen Materialschicht auf der mindestens einen ebenen Substratfläche aufweist,
- wobei der Schichtenaufbau hergestellt wird durch folgende Schritte:
   - Erwärmung mindestens eines Teils der ebenen Substratfläche auf eine Temperatur von mindestens 100 °C und höchstens 550 °C, und zwar für die Dauer der Herstellung des Schichtenaufbaus,
   - Reinigen der Substratfläche durch Zuführen von Wasserstoff oder Sauerstoff oder einem anderen reaktiven Gas aus einer ersten oder einer zweiten Materialquelle und einem Plasma,
   - Terminieren der Substratfläche durch Aufbringen von Kohlenstoff, Stickstoff oder Sauerstoff aus der ersten Materialquelle oder aus einer weiteren Materialquelle und einem Plasma und
   - Aufwachsenlassen der mindestens einen Materialschicht durch Zuführen von Material aus der ersten oder der zweiten Materialquelle und der weiteren oder einer anderen Materialquelle zu der mindestens einen ebenen Substratfläche,
- wobei die Substratschicht eine Oberseite aufweist, die mit einer Vielzahl von durch nicht-ebene Zwischenbereiche voneinander getrennten ebenen Substratflächenbereichen versehen ist und
- wobei das Aufwachsenlassen der Materialschicht nur auf den ebenen Substratflächenbereichen erfolgt.

Bei dem erfindungsgemäßen Verfahren wird aufbauend auf die Herstellung eines Verbundkörpers mit zumindest einer funktionellen Schicht oder die Herstellung eines Verbundkörpers zur weiteren Herstellung elektronischer oder opto-elektronischer Bauelemente nach DE 10 2013 112 785 B3 so fortgefahren, wie es zuvor für verschiedene Varianten der Erfindung beschrieben ist. Die Inhalte der DE 10 2013 112 785 B3 sowie der WO 2015/074989 A1, CN 105723010 A, EP 3 071 723 A1, JP 2017500441 A, TW 201526113 A und US 2016/298261 A1 werden hiermit durch Bezugnahme zum Gegenstand der vorliegenden Patentanmeldung.

Einige der zuvor im Zusammenhang mit der Erfindung verwendete Begriffe sind insbesondere wie folgt zu verstehen.

Als Material für das Substrat bzw. die Substratschicht eignet sich
- Saphir als c-plane, r-plane, m-plane, a-plane mit verschiedenen off-Orientierungen von z.B. 2° off, 4° off, 6° off, 8° off, 10° off usw. oder on-orientiert, und zwar auch in polykristalliner Form,
- Silizium als 111, 100, 001, 010 und 101 mit verschiedenen off-Orientierungen wie 2° off, 4° off, 6° off, 8° off, 10° off usw. oder on-orientiert, und zwar auch in polykristalliner Form,
- Zinkoxid, Siliziumkarbid, Galliumarsenid, Lithiumaluminate, Germanium, Aluminiumnitrid, Galliumnitrid o.dgl., jeweils mit verschiedenen Kristallmodifikationen und Kristallorientierungen und/oder mit verschiedenen off-Orientierungen wie 2° off, 4° off, 6° off, 8° off, 10° off usw. oder on-orientiert, und zwar auch in polykristalline Form,
- Kunststoff, Metalle, Keramikmaterialien.

Das Substratmaterial bzw. die Substratschicht kann erforderlichenfalls gekühlt werden.

Als Materialien für die Abdeckschicht kommen Metalle, keramische Materialien, Halbleitermaterialien, elektrische Isolatoren, SiOₓ, SiNₓ in Frage.

Die Maskierung oder Strukturierung der im Zusammenhang mit der Erfindung beschriebenen Schichten auf dem Substrat bzw. des Substrats erfolgt zweckmäßigerweise durch nasschemisches Ätzen, Trockenätzen, Laser- oder Elektronenstrahlbehandlung oder durch Fotolithographie oder durch Kombinationen dieser Varianten.

Durch das Strukturieren einer durch das Verfahren nach DE 10 2013 112 785 B3 auf einem Substrat hergestellten Basisschicht oder einer oder mehrerer weiterer Schichten als Abdeckschicht oder Abdecklage, die sich auf der Basisschicht befindet und welche aus einem Metall, einer Metalllegierung, einer metallischen Mehrschichtstruktur, einer Keramik oder Keramikstruktur, einer transparenten, leitfähigen Schicht oder aus einer oder mehreren einkristallinen oder polykristallinen Halbleiter- oder (Elektro-)Isolatorschichten besteht, können für die nachfolgenden Schichten besondere Vorteile entstehen:
- Die Kontaktfläche zum Substrat, auf welcher sich die Basisschicht befindet, wird verringert. Dadurch existiert eine geringere Verbiegung bei unterschiedlichen Materialien und damit eine geringe Materialspannung.
- Wegen der Verringerung der Kontaktfläche des auf dem strukturierten Schichtenaufbau bzw. Substrat wachsenden Materials zum Schichtenaufbau bzw. Substrat lässt sich das aufgewachsene Material einfach abtrennen.
- Bei einkristallinen Schichten kann durch die fehlende Kristallvorgabe/-information besonders defektarm (höhere Kristallqualität) an den zu überwachsenden Stellen abgeschieden werden (siehe Motivation).
- Im Falle von optischen Strukturen kann durch ein passendes Muster in der Struktur mehr Licht eingekoppelt (für Solar) oder auch ausgekoppelt (für LED) werden. Auch kann bei gezielter Wahl der Strukturschichtdicke und des optischen Brechungsindexes eine Verstärkung und/oder Totalreflektion eines bestimmten optischen Spektrums erzielt werden.
- Die Struktur auf dem Substrat kann aus einem Material bestehen, welche die Verlustwärme besser auskoppelt.
- Die Struktur (der Abdeckschicht) auf dem Substrat kann auch aus einem Material bestehen, welches als elektrischer (ohmscher oder Schottky-) Kontakt genutzt werden kann oder als Basis dient, um mit einem weiteren Material (kann auch ein Metall, eine Metalllegierung, eine metallische Mehrschichtstruktur, eine Keramik oder Keramikstruktur, eine transparente leitfähige Schicht sein oder aus einer oder mehreren einkristallinen oder polykristallinen Halbleiter oder Isolatorschichten bestehen) einen besonderes niederohmigen Übergang oder einem Schottky-Kontakt zu erzeugen.
- Je nach Wahl des Materials der Abdeckschicht kann das Ablösen des Substrats von dem aufgewachsenen Material vereinfacht sein, indem das Substrat z.B. bei Verdrehen gegenüber dem aufgewachsenen Material durch Abscheren getrennt wird. Durch die Strukturierung sind die Anzahl und Größten der Verbindungsstellen des aufgewachsenen Materials mit dem Substrat minimiert, so dass bei Anwendung eines Trennprozesses unter Einsatz eines Lasers zum Aufschmelzen der Verbindung schneller und gearbeitet werden kann.

Die Strukturierung der Abdeckschicht kann dabei mittels eines Materials entstehen, welches ganzflächig aufgetragen wird und anschließend durch einen trocken- oder nasschemischen Prozess strukturiert wird. Dabei kann das Material vor der Basisschicht auftragen und strukturiert werden oder nach dem Wachsen der Basisschicht. Beim Strukturieren kann das Muster auch in das Substrat ragen. Die Strukturierung kann auch auf das Substrat oder auf die Basisschicht übertragen werden, so dass kein weiteres Material zum Substrat und der Basisschicht hinzukommt. Die Strukturierung kann auch erst auf das Substrat übertragen werden. Neu ist hier das Überwachsen mit dem Verfahren nach DE 10 2013 112 785 B3. Ähnlich auch bei einer Strukturierung von einem anderen Material auf dem Substrat, um es dann, wie in DE 10 2013 112 785 B3 beschrieben, mit einer Basisschicht zu überwachsen. Beispiele für verschiedene Optionen sind in den Fign. 2 bis 5 schematisch gezeigt.

Das Material kann dabei in Form von Isolatorschichten wie z.B. Siliziumoxid, Aluminiumoxid, Siliziumnitrid, Siliziumkarbid, Bornitrid oder anderen dem Fachmann bekannten elektrischen Isolatorschichten vorliegen. Das Material kann aber auch aus einem Metall wie Titan, Zirconium, Hafnium, Molybdän, Mangan und weiteren Metallen bestehen, welche physikalisch in den nachfolgenden Beschichtungsverfahren gewachsen sind.

Wird mit dem Verfahren nach DE 10 2013 112 785 B3 weiter gewachsen, ist die Freiheit bei der Materialwahl deutlich höher.

Bei Metallen kann es sich auch um metallische Mehrschichtstrukturen, Metallverbindungen und Legierungen handeln. Das Material kann aber auch aus transparenten leitfähigen Schichten bestehen oder aus einer oder mehreren einkristallinen oder polykristallinen Halbleiter- oder Isolatorschichten bestehen.

Die Struktur kann so aussehen, dass die Dimensionen so groß sind, dass nur lokal begrenzte Segmente entstehen, die sich nicht mit dem Nachbarsegment verbinden. Dadurch wird direkt am Anfang die Dimensionen der nachfolgenden Bauelemente (LED, Transistor, ...) definiert. Vorteile bieten sich hier bei der Lichtauskopplung und einer direkten Mesa-Isolierung. Auch können epitaktische Grenzflächen gebildet werden, die im Falle von z.B. GaN auf Saphir nicht durch Brechen entstehen können, da die Schicht verdreht aufwächst.

Die Dimensionen der Struktur können so ausgelegt werden, dass angrenzende Segmente sich mit den Nachbarsegmenten zu einem Ganzen verbinden können.

Die Struktur kann auch aus vielen sehr kleinen Öffnungen bestehen, so dass abhängig von den Wachstumsbedingungen der Folgeschichten aus diesen Öffnungen Säulen gewachsen werden (siehe z.B. WO2008/085129 A1, WO2009/ 031276 A1, WO2009/069286 A1, WO2010/023921 A1, https://www.led-professional.com/technology/light-generation/osram-opto-demonstrates-3d-nanoleds-for-white-light-and-sees-series-maturity-in-coming-years und https://www.aledia.com/en/).

Die Erfindung wird nachfolgend anhand der Zeichnung weiter erläutert. Im Einzelnen zeigen dabei:
- Fig. 1: ein Beispiel für die Defektreduktion bei der Heteroepitaxie durch Maskierung mit einer lokal begrenzten SiO₂-Schicht (Quelle: http://www.ifkp.tu-berlin.de/fileadmin/i1/Kneissl/IS08_GaN-Laser_FG, Abb. 18, Seite 18),
- Fign. 2 bis 5: schematisch die Möglichkeiten der Strukturierung, wie sie gemäß diverser Ausführungsbeispiele der Erfindung eingesetzt werden,
- Fign. 6 und 7: Beispiele für mögliche neuartige Transistorstrukturen, die basierendauf einem erfindungsgemäß hergestellten Verbundmaterialkörper her-stellbar sind, wobei die Fign. 6a und 6b den Fall betreffen, dass aufdem Substrat vor dem Aufwachsenlassen der Materialschicht eine Me-tallstrukturbeschichtung aufgebracht ist, während Fign. 7a und 7b denFall betreffen, dass die Metallstrukturbeschichtung erst nach dem aufdem Substrat erfolgenden Wachstum des Materials und damit auf demgewachsenen Material vorgenommen wird, und
- Fign. 8 und 9: Beispiele für mögliche optische Bauelemente mit Braggreflektoren als Struktur auf einer durch Aufwachsen auf einer auf einem Substrat selbst aufgewachsenen Materialschicht, wobei die Fign. 8a und 8b eine erste Form von Braggreflektoren und die Fign. 9a und 9b eine zweite Form von Braggreflektoren zeigen.

Nachfolgend werden anhand der Fign. 2 bis 7 Fallbeispiele für AIN auf Saphir oder Silizium (Si-111) zur Weiterverwendung in Verfahren wie z.B. Atomic layer deposition (ALD), Plasma enhanced chemical vapor depositions (PECVD), magnetron sputter epitaxy, Sputterdeposition, reaktive Sputterdeposition, thermisches Verdampfen, Elektronstrahl Verdampfen, Laserstrahl-Verdampfung, ion beam deposition, Flüssigphasenepitaxy (liquid phase epitaxy), pulsed laser deposition, laser-assisted PECVD, Hydrid oder Halide vapor phase epitaxy (HVPE), MOCVD oder Molecular beam epitaxy (MBE) für Pufferschichten, LED-Strukturen und anderen elektronischen Strukturen (z.B. Hetero-Feldeffekttransistoren) beschrieben.

Fig. 2 zeigt ein Beispiel für eine subtraktive Strukturierung des Substrats und dessen Überwachsenlassen mit einer Materialschicht gemäß dem Verfahren nach DE 10 2013 112 785 B3, wobei die Strukturierung der einkristallin aufwachsenden Materialschicht durch vorheriges lokal begrenztes Abtragen und Aufrauen der Substratoberfläche und anschließendes Überwachsen dieses Substrats entsteht.

Dabei wird eine AlN-Basisschicht 10 gemäß dem Verfahren nach DE 10 2013 112 785 B3 auf einem Substrat 12 (Saphir oder Silizium-111) gewachsen, eine 3D-Struktur 14 (wie z.B. bekannt aus US 8 871 652 B2, US 9 484 492 B2, US 2011/0168670 A1, US 2017/0062655 A1, EP 2 644 756 A1, und https://pubs.acs.org/doi/abs/10.1021/cg2016534) aufweist. Die Struktur 14 kann z.B. aus einem Schachbrettmuster, Streifen, Wellen, Pyramiden, Zylinder (auch konische Zylinder) bestehen. Dabei wird das AIN der Basisschicht 10 einkristallin nur auf den erhabenen Bereichen 16 der Struktur 14 gewachsen. Soll anschließend in einem z.B. MOCVD-Prozess z.B. GaN (oder andere Schichten wie AIN, AIGaN, InGaN, AlInN, dotiert oder undotiert) aufgewachsen werden, so wächst dieses Material nur auf dem AIN auf den erhabenen Bereichen 16 der Struktur 14. Nach dem Überwachsen entsteht eine zusammenhängende GaN-Schicht (nicht dargestellt), wobei diejenigen Bereiche der GaN-Schicht, die durch Überwachsen der erhabenen Bereiche 16 der (Oberflächen-)Struktur 14 entstanden sind, besonders defektarm sind.

Fig. 3 zeigt ein Beispiel für eine subtraktive Strukturierung der nach DE 10 2013 112 785 B3 hergestellten Materialschicht, die zunächst auf dem Substrat aufwächst, so dass die Struktur anschließend durch Abtragen und Aufrauen lokaler Bereiche der Materialschicht, gegebenenfalls bis zum Substrat hinunter, übertragen wird.

Hierbei wird die Struktur 14 k auf die AlN-Basisschicht 10 übertragen. Dabei wird das AIN als Basisschicht 10 auf ein Substrat 12 (Saphir oder Si-111) aufgetragen und anschließend wird entweder nur das AIN strukturiert (siehe die gestrichelten Linien) oder gegebenenfalls die Strukturierung bis in die Oberfläche des Substrats 12 hinein fortgesetzt, was sich beides abhängig vom Substrat 12 einfacher realisieren lässt als das Substrat 12 zu strukturieren (Saphir ist besonders stabil), wie in dem Ausführungsbeispiel der Fig. 2 vorgeschlagen. Beim Überwachsen entstehen die gleichen Vorteile für das Aufwachsenlassen weiterer Schichten (z.B. GaN), wie zuvor im Zusammenhang mit Fig. 2 beschrieben.

Fig. 4 zeigt ein Beispiel für eine additive Strukturierung der Materialschicht nach DE 10 2013 112 785 B3, wobei das Substrat mit dieser Materialschicht bedeckt wird und nur diese Materialschicht strukturiert wird.

Die Struktur 14 wird dabei auf eine Abdeckschicht 18 übertragen, welche auf die zuvor auf dem Substrat 12 gewachsene AlN-Basisschicht abgeschieden wird. Die Abdeckschicht 18 kann eine Metall-Schicht/Legierung sein, eine transparente leitfähige Schicht oder ein Isolator, welcher anschließend strukturiert wird. Dabei entstehen die gleichen Vorteile für das Aufwachsenlassen weiterer Schichten (z.B. GaN) wie zuvor. Die Struktur kann auch aus kleinen Öffnungen bestehen, so dass mit den passenden Wachstumsbedingungen nur Material-Säulen (z.B. GaN-Säulen) gewachsen werden. Es können auch katalytische Materialien in der Struktur (hier kann sie auch ganzflächig sein) vorhanden sein, welche sich für sogenanntes "nano-wire"-Wachstum eignen.

Fig. 5 betrifft ein Beispiel für eine additive Strukturierung des Substrats mit Überwachsen durch eine AlN-Schicht, wobei dann das Muster durch Abtragen und Aufrauen bis zum Substrat übertragen werden kann, um anschließend die AlN-Schicht weiter zu überwachsen.

Hierbei wird eine AlN-Basisschicht 10 wird gemäß dem Verfahren nach DE 10 2013 112 785 B3 auf einem Substrat (Saphir oder Silizium-111) 12 gewachsen, auf welchem eine Abdeckschicht 18 (z.B. SiOx oder SiNx) aufgebracht ist, die eine 3D-Struktur 14 (wie z.B. bekannt aus US 8 871 652 B2, US 9 484 492 B2, US 2011/0168670 A1, US 2017/0062655 A1, EP 2 644 756 A1, und https://pubs.acs.org/doi/abs/10.1021/cg2016534) aufweist, die an der Oberfläche des Substrats 12 endet oder sich noch bis in die Oberfläche des Substrats 12 fortsetzen kann. Die Struktur 14 kann z.B. aus einem Schachbrettmuster, Streifen, Wellen, Pyramiden, Zylinder (auch konische Zylinder) bestehen. Dabei wird das AIN der Basisschicht 10 einkristallin nur in den flachen Tälern 20 der Struktur 14 gewachsen. Soll anschließend in einem z.B. MOCVD-Prozess z.B. GaN (oder andere Schichten wie AIN, AIGaN, InGaN, AlInN, dotiert oder undotiert) aufgewachsen werden, so wächst dieses Material nur in den Tälern 20 auf dem Substrat 12 einkristallin auf. Nach dem Überwachsen entsteht eine zusammenhängende GaN-Schicht (nicht dargestellt), wobei diejenigen Bereiche der GaN-Schicht, die durch Überwachsen der strukturierten Abdeckschicht 18 entstanden sind, besonders defektarm sind.

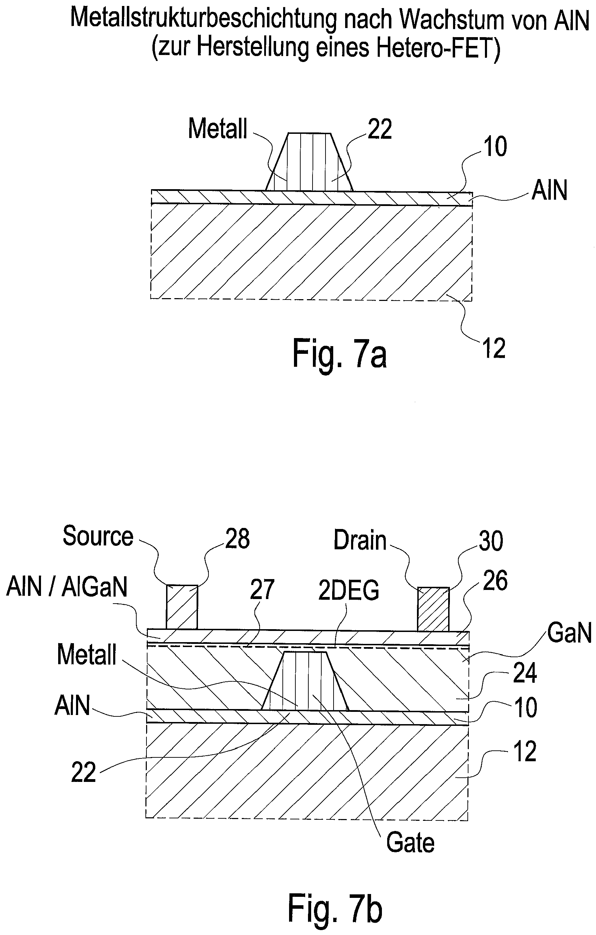

Für sämtliche Fallbeispiele gilt, dass die Struktur, auf der z.B. ein GaN-Wachstum erfolgt, auch so geformt sein kann (auf dem Substrat oder auf der AIN-Schicht oder der Strukturschicht), dass aufwachsende Segmente des Wachstum-Materials einen derart großen Abstand voneinander aufweisen, dass Nachbarsegmente nicht miteinander verbunden sind (wie z.B. in Alois Krost, Armin Dadgar, "GaN-based optoelectronics on silicon substrates", Materials Science and Engineering B93 (2002) 77-84, siehe Kapitel 9, Fig. 7 beschrieben). Dadurch entstehen bereits isolierte Bauelemente. Eine LED hat dann bereits perfekte Kanten und könnte der Lichtauskopplung oder als Kanteremitter-Laser dienen. Ein Transistor wäre bereits als Bauelement isoliert, was die Kontaktierung vereinfacht.

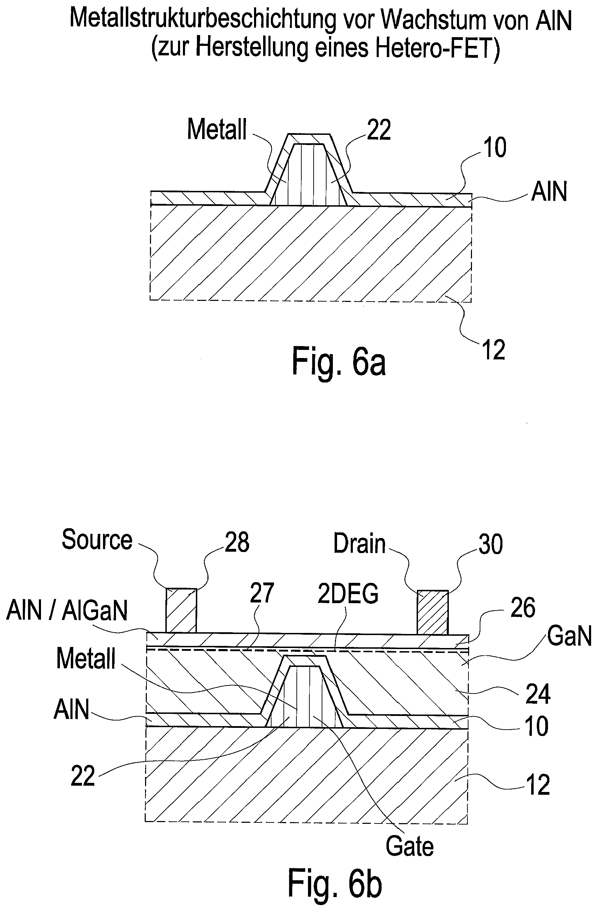

In den Fign. 6 und 7 sind zwei Beispiele für eine mögliche neuartige Struktur von Hetero-Feldeffekttransistoren gezeigt, die sich basierend auf einem Verbundmaterialkörper nach der Erfindung bzw. nach dem erfindungsgemäßen Verfahren hergestellt realisieren lassen.

In Fig. 6a ist gezeigt, dass das Substrat 12 zunächst mit einer Metallstruktur 22 versehen wird, um dann anschließend nach dem Verfahren gemäß DE 10 2013 112 785 B3 Material (beispielsweise AIN) als Basisschicht 10 aufwachsen zu lassen.

Durch anschließendes Aufwachsenlassen z.B. einer GaN-Schicht 24, darauffolgendes Auftragen einer weiteren Schicht 26 aus z.B. AIN oder AIGaN zum Bilden eines zweidimensionalen Elektronengases (2DEG), angedeutet durch die gestrichelte Linie 27, auf Grund des Heteroübergangs des AIN bzw. AIGaN zur GaN-Schicht 24, lässt sich dann ein Hetero-Feldeffekttransistor realisieren (siehe Fig. 6b), indem das Strukturelement der Metallstrukturbeschichtung 22 als Gate fungiert, während auf der Isolationsschicht 26 beidseitig der Metallstrukturbeschichtung 22 Source- und Drain-Anschlüsse 28, 30 aufgebracht werden.

In Fig. 7a ist eine Variante zum Ausführungsbeispiel gemäß den Fign. 6a und 6b gezeigt. Bei dieser Variante wird zunächst auf das Substrat nach dem Verfahren gemäß DE 10 2013 112 785 B3 als Basisschicht 10 eine z.B. AIN aufgebracht, um dann auf dieser Basisschicht 10 die Metallstrukturbeschichtung 22 aufzubringen. Der weitere Prozess der Herstellung eines Hetero-Feldeffekttransistors erfolgt dann so, wie zuvor beschrieben, wobei das Ergebnis dieses Prozesses in Fig. 7b schematisch gezeigt ist.

Wie gezeigt, kann der erfindungsgemäß strukturierte Verbundmaterialkörper für Transistorschichten auch als Gate-Metall verwendet werden. Der Abstand und die Höhe der Gate-Metall-Streifen (Metallstrukturbeschichtung 22) können abhängig von der geforderten Transistorschicht direkt auf das Substrat aufgetragen werden, um anschließend von der Basisschicht 10 überwachsen zu werden (siehe Fign. 6a und 6b) oder aber um auf die zuvor aufgewachsene Basisschicht 10 aufgetragen zu werden (siehe Fign. 7a und 7b).

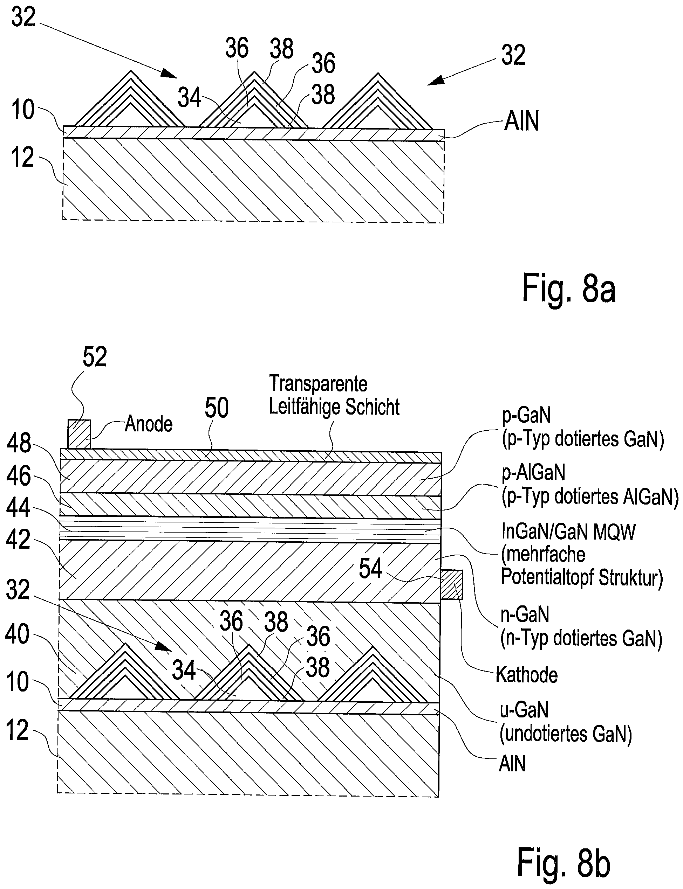

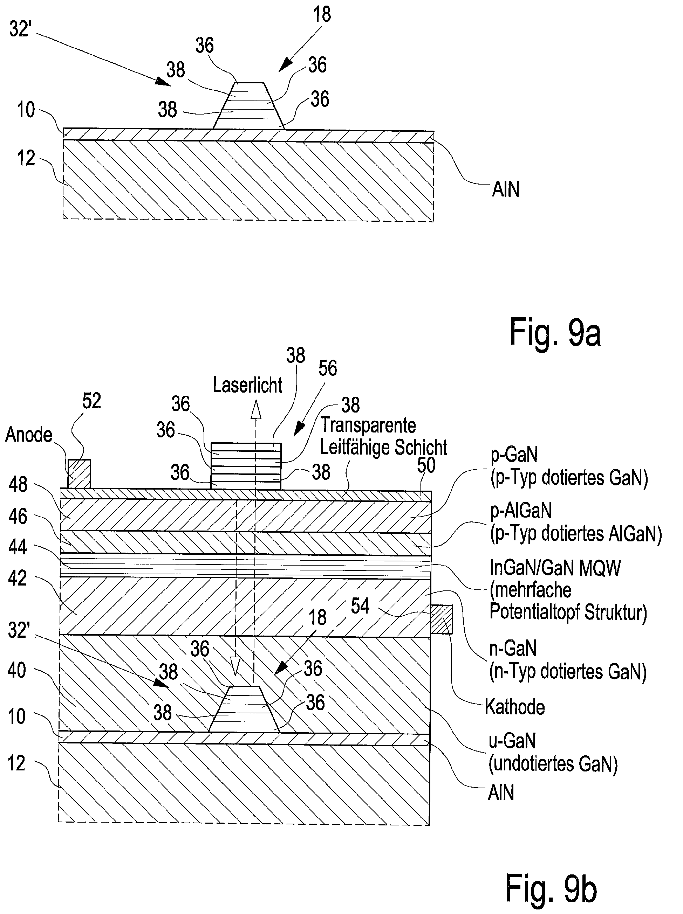

In den Fign. 8a und 9b ist eine erste Variante für die nach einer Ausführungsform der Erfindung aufgewachsene Struktur als Braggreflektor mit einem Übergitter aus beispielsweise SiNₓ oder SiOₓ gezeigt. Der Braggreflektor 32 ist tetraederförmig oder prismatisch und weist einen dementsprechend geformten Kern 34 auf, auf dessen Schrägflächen wechselweise SiNₓ-Schichten 36 und SiOₓ-Schichten 38 aufgewachsen sind. Diese Struktur befindet sich auf einer beispielsweise AlN-Basisschicht 10, die ihrerseits auf ein Substrat 12 aufgewachsen ist. Die wechselweise aufgetragenen SiNₓ-Schichten 36 und SiOₓ-Schichten 38 bilden zusammen den Braggreflektor 32, der an seinen Schrägen reflektiert. Dadurch kann das Licht einer auf dieser Struktur aufbauend hergestellten LED (siehe Fig. 8b) besser ausgekoppelt werden. Im Falle der Anwendung bei einer Solarzelle kann ein bestimmtes Spektrum zurück zur aktiven Ebene reflektiert werden. Die Übergitterstruktur des Braggreflektors 32 kann alternativ zu der hier beschriebenen Ausführungsform auch vor dem Aufbringen der AIN-Basisschicht aufgetragen sein, also dann direkt auf das Substrat 12 aufgetragen sein.

In Fig. 8b ist gezeigt, dass die Braggreflektor-Struktur von einer Schicht 40 beispielsweise aus undotiertem GaN überdeckt ist. Auf dieser Schicht 40 befindet sich eine weitere Halbleiterschicht 42 aus in diesem Fall n-Typ dotiertem GaN. Auf dieser Schicht 42 wiederum befindet sich eine MOW-(multiple-quantum-well-) Schicht 44 aus InGaN oder aus GaN. Die MOW-Schicht 44 bildet eine Mehrfach-Potentialtopf-Struktur.

Auf die MOW-Schicht 44 wird dann eine Schicht 46 aus p-Typ dotiertem AIGaN aufgebracht, um auf dieser Schicht 46 ein p-Typ dotiertes GaN 48 aufzutragen. Dieser Schichtenstapel wird schließlich abgedeckt von einer transparenten elektrisch leitfähigen Schicht 50, die einen elektrischen Kontakt 52 als Anode aufweist. Der zweite Anschluss 54, d.h. die Kathode, befindet sich in elektrischer Verbindung mit der Schicht 42 aus n-Typ dotiertem GaN.

In den Fign. 9a und 9b ist ein ähnlicher Aufbau eines optischen Bauelements gezeigt wie in den Fign. 8a und 8b. Die zuvor im Zusammenhang mit den Fign. 8a und 8b beschriebenen Schichtenfolgen sind im Wesentlichen identisch, mit Ausnahme der Ausbildung und damit der Schichtenfolge und deren geometrischen Form des Braggreflektors 32' und einer zusätzlichen Schichtenfolge in Ausrichtung mit dem Braggreflektor 32' auf der transparenten elektrisch leitfähigen Schicht 50. Der Braggreflektor 32' weist eine trapezförmige oder pyramidenförmige Form auf und ist aufbauend auf einer Grundschicht 34 durch wechselweises Aufbringen von SiNₓ-Schichten 36 und SiOₓ-Schichten 38 hergestellt (siehe Fig. 9a). Dabei ist es möglich, dass diese Übergitterstruktur anstelle des Auftrags auf der beispielsweise AlN-Basisschicht 10 direkt auf dem Substrat aufgebracht sein kann.

Die weiteren Schichtenfolgen zur Herstellung des optischen Bauelements sind ähnlich bzw. identisch mit denen der Fig. 8b, wie man anhand der Fig. 9b erkennen kann.

Der Braggreflektor 32' bildet den Basisspiegel für eine oberflächenimitierende Laserdiode oder auch LED. Im Unterschied bzw. zusätzlich zu dem Schichtenaufbau des optischen Bauelements nach Fig. 8b ist im Schichtenaufbau des optischen Bauelements der Fig. 9b noch ein weiterer Braggreflektor 56 vorgesehen, und zwar auf der transparenten elektrisch leitfähigen Schicht 50 und in Ausrichtung mit dem Braggreflektor 32'. In Fig. 9b ist durch die gestrichelten Pfeile der Pfad des "vor- und zurücklaufenden" Laserlichts mit Auskopplung am Braggreflektor 56 gezeigt.

Die beiden Varianten für optische Bauelemente gemäß den Fign. 8 und 9 dienen beispielsweise der Herstellung von nah-UV, blauen oder grünen Laserdioden bzw. LEDs. Für bei kleineren Wellenlängen abstrahlende UV-LEDs bestehen die Schichten aus AIGaN mit verschiedenen Al-Kompositionen und statt des undotierten GaN aus AIN.

### BEZUGSZEICHENLISTE

- 10: (AIN-)Basisschicht
- 12: Substrat
- 14: 3D-Struktur
- 16: Bereiche
- 18: Abdeckschicht
- 20: Täler
- 22: Metallstruktur
- 24: GaN-Schicht
- 26: Schicht zum Bilden eines zweidimensionalen Elektronengases (2DEG)
- 27: zweidimensionales Elektronengas in der Grenzebene der Schicht 26 zur GaN-Schicht 24
- 28: Drain-Anschlüsse
- 30: Drain-Anschlüsse
- 32: Braggreflektor
- 32': Braggreflektor
- 34: Kern des Braggreflektors
- 36: SiNₓ-Schicht des Übergitters
- 38: SiOₓ-Schicht des Übergitters
- 40: Schicht aus n-dotiertem GaN
- 42: Schicht aus n-Typ dotiertem GaN
- 44: MOW-Schicht
- 46: Schicht aus p-Typ dotiertem AIGaN
- 48: Schicht aus p-Typ dotiertem GaN
- 50: transparente elektrisch leitfähige Schicht
- 52: Anode
- 54: Kathode
- 56: Braggreflektor

## Patentansprüche

1. Verfahren zur Herstellung eines Verbundmaterialkörpers insbesondere für die Verwendung bei der Herstellung von elektronischen oder opto-elektronischen Bauelementen, wobei bei dem Verfahren
- ein Schichtenaufbau bereitgestellt wird, der eine Substratschicht mit mindestens einer ebenen Substratfläche und mit mindestens einer polykristallinen oder einkristallinen oder im Wesentlichen einkristallinen Materialschicht auf der mindestens einen ebenen Substratfläche aufweist,
- wobei der Schichtenaufbau hergestellt wird durch folgende Schritte:
- Erwärmung mindestens eines Teils der ebenen Substratfläche auf eine Temperatur von mindestens 100 °C und höchstens 550 °C, und zwar für die Dauer der Herstellung des Schichtenaufbaus,
- Reinigen der Substratfläche durch Zuführen von Wasserstoff oder Sauerstoff oder einem anderen reaktiven Gas aus einer ersten oder einer zweiten Materialquelle und einem Plasma,
- Terminieren der Substratfläche durch Aufbringen von Kohlenstoff, Stickstoff oder Sauerstoff aus der ersten Materialquelle oder aus einer weiteren Materialquelle und einem Plasma und
- Aufwachsenlassen der mindestens einen Materialschicht durch Zuführen von Material aus der ersten oder der zweiten Materialquelle und der weiteren oder einer anderen Materialquelle zu der mindestens einen ebenen Substratfläche,
**dadurch gekennzeichnet,**
- **dass** auf die Materialschicht eine das Aufwachsenlassen von polykristallinem oder einkristallinem oder im Wesentlichen einkristallinem Material verhindernde Abdeckschicht aufgebracht wird, die zur Erzeugung von Öffnungen oder Vertiefungen maskiert ist und/oder maskiert wird, wobei innerhalb der Öffnungen oder Vertiefungen die auf dem Substrat aufgewachsene Materialschicht freiliegt.

2. Verfahren zur Herstellung eines Verbundmaterialkörpers insbesondere für die Verwendung bei der Herstellung von elektronischen oder optoelektronischen Bauelementen, wobei bei dem Verfahren
- ein Schichtenaufbau bereitgestellt wird, der eine Substratschicht mit mindestens einer ebenen Substratfläche und mit mindestens einer polykristallinen oder einkristallinen oder im Wesentlichen einkristallinen Materialschicht auf der mindestens einen ebenen Substratfläche aufweist,
- wobei der Schichtenaufbau hergestellt wird durch folgende Schritte:
- Erwärmung mindestens eines Teils der ebenen Substratfläche auf eine Temperatur von mindestens 100 °C und höchstens 550 °C, und zwar für die Dauer der Herstellung des Schichtenaufbaus,
- Reinigen der Substratfläche durch Zuführen von Wasserstoff oder Sauerstoff oder einem anderen reaktiven Gas aus einer ersten oder einer zweiten Materialquelle und einem eigens Plasma,
- Terminieren der Substratfläche durch Aufbringen von Kohlenstoff, Stickstoff oder Sauerstoff aus der ersten Materialquelle oder aus einer weiteren Materialquelle und einem Plasma und
- Aufwachsenlassen der mindestens einen Materialschicht durch Zuführen von Material aus der ersten Materialquelle oder der zweiten und der weiteren oder einer anderen Materialquelle zu der mindestens einen ebenen Substratfläche,
**dadurch gekennzeichnet,**
- **dass** die aufgewachsene Materialschicht zur Ausbildung von einzelnen Inseln mit bis zur Substratschicht tiefen oder mit sich bis in die Substratschicht hinein erstreckenden Aussparungen strukturiert wird.

3. Verfahren zur Herstellung eines Verbundmaterialkörpers insbesondere für die Verwendung bei der Herstellung von elektronischen oder optoelektronischen Bauelementen, wobei bei dem Verfahren
- ein Schichtenaufbau bereitgestellt wird, der eine Substratschicht mit mindestens einer ebenen Substratfläche und mit mindestens einer polykristallinen oder einkristallinen oder im Wesentlichen einkristallinen Materialschicht auf der mindestens einen ebenen Substratfläche aufweist,
- wobei der Schichtenaufbau hergestellt wird durch folgende Schritte:
- Erwärmung mindestens eines Teils der ebenen Substratfläche auf eine Temperatur von mindestens 100 °C und höchstens 550 °C, und zwar für die Dauer der Herstellung des Schichtenaufbaus,
- Reinigen der Substratfläche durch Zuführen von Wasserstoff oder Sauerstoff oder einem anderen reaktiven Gas aus einer ersten oder einer zweiten Materialquelle und einem Plasma,
- Terminieren der Substratfläche durch Aufbringen von Kohlenstoff, Stickstoff oder Sauerstoff aus der ersten Materialquelle oder aus einer weiteren Materialquelle und einem Plasma und
- Aufwachsenlassen der mindestens einen Materialschicht durch Zuführen von Material aus der ersten oder der zweiten Materialquelle und der weiteren oder einer anderen Materialquelle zu der mindestens einen ebenen Substratfläche,
**dadurch gekennzeichnet,**
- **dass** die Substratschicht zur Erzeugung einer strukturierten Oberfläche mit erhabenen Bereichen und mit Vertiefungen zwischen diesen bearbeitet wird,
- wobei die erhabenen Bereiche Oberseiten mit jeweils mindestens einer ebenen Oberfläche und die Vertiefungen nicht-ebene, insbesondere raue, Bodenflächen, oder umgekehrt, aufweisen und
- **dass** nach den oben genannten Schritten des Erwärmens, des Reinigens und des Terminierens das Aufwachsenlassen von Material der Materialschicht nur auf den ebenen Oberflächen der erhabenen Bereiche erfolgt.

4. Verfahren zur Herstellung eines Verbundmaterialkörpers insbesondere für die Verwendung bei der Herstellung von elektronischen oder optoelektronischen Bauelementen, wobei bei dem Verfahren
- ein Schichtenaufbau bereitgestellt wird, der eine Substratschicht mit mindestens einer ebenen Substratfläche und mit mindestens einer polykristallinen oder einkristallinen oder im Wesentlichen einkristallinen Materialschicht auf der mindestens einen ebenen Substratfläche aufweist,
- wobei der Schichtenaufbau hergestellt wird durch folgende Schritte:
- Erwärmung mindestens eines Teils der ebenen Substratfläche auf eine Temperatur von mindestens 100 °C und höchstens 550 °C, und zwar für die Dauer der Herstellung des Schichtenaufbaus,
- Reinigen der Substratfläche durch Zuführen von Wasserstoff oder Sauerstoff oder einem anderen reaktiven Gas aus einer ersten oder einer zweiten Materialquelle und einem Plasma,
- Terminieren der Substratfläche durch Aufbringen von Kohlenstoff, Stickstoff oder Sauerstoff aus der ersten Materialquelle oder aus einer weiteren Materialquelle und einem Plasma und
- Aufwachsenlassen der mindestens einen Materialschicht durch Zuführen von Material aus der ersten oder der zweiten Materialquelle und der weiteren oder einer anderen Materialquelle zu der mindestens einen ebenen Substratfläche,
**dadurch gekennzeichnet,**
- **dass** auf der Substratschicht eine das Aufwachsenlassen von polykristallinem oder einkristallinem oder im Wesentlichen einkristallinem Material verhindernde Abdeckschicht aufgebracht wird, die zur Erzeugung von bis zur ebenen Substratfläche tiefen Öffnungen oder Aussparungen maskiert ist und/oder maskiert wird, und
- **dass** nach den oben genannten Schritten des Erwärmens, des Reinigens und des Terminierens zumindest innerhalb der Aussparungen und ggf. darüber hinaus nach oben erstreckend Material der Materialschicht aufwächst.

5. Verfahren nach einem der Ansprüche 1 bis 4, **dadurch gekennzeichnet, dass** die Materialschicht und/oder das aufwachsende Material ein Halbleitermaterial, insbesondere ein polykristalliner oder einkristalliner oder im Wesentlichen einkristalliner Element- oder Verbindungshalbleiter ist oder ein keramischer Werkstoff ist oder ein metallischer Hartstoff ist, der z.B. eine Vickers-Härte von mehr als 1000 vH und/oder eine Mohs-Härte von mehr als 9,0 und dessen überwiegender Anteil metallische Bindungen aufweist, wie z.B. Titannitrid (TiN).
